# NEW EUROPEAN PATENT SPECIFICATION

(11) **EP 1 963 721 B2**
(45) Date of publication and mention of the opposition decision: **20.07.2016**
(45) Mention of the grant of the patent: 26.08.2009
(21) Application number: 06755934.4
(22) Date of filing: 02.06.2006
(51) Int. Cl.: F16J 9/26

(54) **PISTON RING FOR INTERNAL COMBUSTION ENGINES**
KOLBENRING FÜR VERBRENNUNGSMOTOREN
SEGMENT DE PISTON POUR MOTEURS A COMBUSTION INTERNE

(30) Priority: 21.12.2005 BR PI0506343
(43) Date of publication of application: 03.09.2008
(73) Proprietor: Mahle International GmbH, 70376 Stuttgart (DE); Mahle Metal Leve S.A., CEP-04746-901 Sao Paulo, SP (BR)
(72) Inventor: SARABANDA, José Valentim Lima, Sao Paulo, SP (BR); BANFIELD, Robert Richard, Sao Paulo, SPP (BR); MARQUES, Gisela Ablas, Sao Paulo, SP (BR)
(74) Representative: Stumkat, Ulrich
(86) International application number: PCT/IB2006/001444
(87) International publication number: WO 2006/131801

(56) References cited:
- GB-A- 2 276 176
- US-A- 5 743 536
- US-A- 6 149 162

## Description

### BACKGROUND OF THE INVENTION

### 1. Technical Field of the Invention

The invention relates to a piston ring for internal combustion engines, consisting of a steel or cast iron base material with a coating of chromium nitride deposited by a physical vapor deposition process on a sliding surface of the piston ring.

### 2. Related Art

The use of a chromium nitride film with typical crystal structure of CrN phase on the outer peripheral surface of a piston ring provides high wear resistance for this component. This film Is widely used in modem engines, latest developments, with high mechanical and thermal loads. Such a coating is obtained by physical metallic vapor deposition generated by a source of cathodic arc.

However, in some recent engines, extremely highly loaded or in engines with a high level of combustion pressure, as the ones designed for the next decade, this ceramic coating of chromium nitride presents an intrinsic fragility which leads to the generation of micro-cracks on its surface. These micro-cracks propagate and their coalescence leads to loss pieces of the coating, damaging its surface and, in some cases, leading to scratches on the engine liners. Scratches of the liners and damage of the running face of the ring are considered a functional failure of the system.

The improvement of resistance to micro-crack generation, which antecedes the loss of material and the scratches of the cylinder liners is presented in specialized literature through the generation of a chromium nitride film having additions of oxygen, carbon and boron, in solid solution form in the crystalline coating of the CrN phase. The addition of these elements is presented as intrinsically responsible for the resistance increase of micro-cracks.

The crystal structure of coatings deposited by a physical vapor process is modified with the addition of small quantities of other reactive gases and this is a classic technique established in the literature, for example by Mattox in the Handbook of Physical Vapor Deposition (PVD) Processing, Noyes Ed, page 486; Year 1998. Literature mentions that films that are physical vapor deposited present columnar crystal morphology with the preferential growth of specific crystal orientations parallel to the surface of the film. The preferred orientation of a specific crystal plane can change the properties of the film and depends on the deposition parameters, such as substrate temperature, addition of reactive gases and ion bombardment.

US Patent No. 5,743,536 mentions that the crystals of CrN might be predominantly oriented with the (111) dense planes parallel to the surface and that with such orientation there is an improvement of the film peeling. Such predominant orientation was obtained by the manipulation of the deposition parameters, with no external addition of other doping elements to the nitrogen reacting gas. However, it is not mentioned whether such orientation is the only one observed, i.e. if preferred orientation means that 100% of the crystal parallel to the surface are of grains with (111) crystal orientation, or in which proportion others crystal orientations are allowed.

Besides this relatively open definition regarding the content of others crystal planes not so dense as (111) planes, the CrN coating produced with the process described in US Patent No. 5,743,536 has a relatively low Vickers hardness of 600 to 1000 HV, which would Jeopardize the film wear resistance, making it not applicable to the recent highly loaded engines.

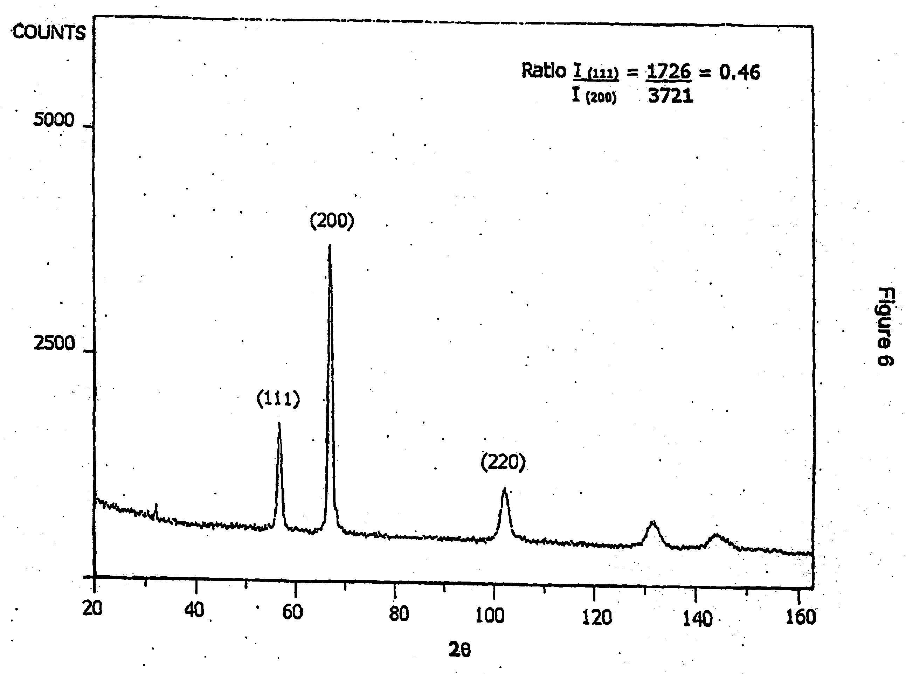

UK Patent No. GB 2,276,176 describes the doping of CrN with 3 to 20 weight percent of oxygen or, alternatively, the doping of CrN with 2 to 11 weight percent of carbon. The main objective of this was to provide a coating with higher wear and scuffing resistance. The possible crystalline change of CrN coating by the addition of oxygen was not brought into discussion or included in the claims of the patent, but an X-ray diffraction chartpresented on figure 6, page 6, showed that CrN structure has a dominant (200) plane after doping with 10 weight percent of oxygen.

US Patent No. 6, 149, 162 describes the deposition of a chromium nitride film with CrN crystal structure having 0.5 to 20 weight percent of oxygen and presenting a microstructure with dominant or preferential orientation of crystal plane (200) parallel to the coating surface. It is mentioned on this patent that a crystal structure of CrN with a preferred orientation of the (111) crystal plane Is brittle in comparison to the preferred orientation of the (200) crystal plane parallel to the coating surface. In this patent, there was a connection of the oxygen addition to the crystalline coating and the consequent alteration of its crystal structure, giving rise to an improvement of the coating resistance concerning the generation of micro-cracks. However, the definition of preferred orientation is very broad; not allowing the definition of predominant level, if it means 100% or if is allowed a residual level of (111) planes described as brittle. Likewise, the definition of preferred orientation does not impose criticality to distinct levels of intensity ratio of crystal planes (111) and (200) in the CrN coating.

Furthermore, it is known that chromium nitride of crystal structure or CrN phase appears on its form established as standardized in nature with intensity ratios between crystal planes (111) and (200), measured by x-ray diffraction, of approximately 0.80. This information is registered on the JCPDS card no. 11 - 65 (Joint Committee of Powder Diffraction Standards) of the database of composts of ICDD - International Centre for Diffraction Data. Therefore, the presence of a predominant plane must be compared to this intensity ratio of crystal planes of the CrN phase of reference.

On the above related state of the art technologies, the chromium nitride coating with CrN crystal structure may be configured with a (111) crystal plane preferred orientation, presenting low hardness associated with the deposition parameters used for the obtainment of this orientation, or a (200) crystal plane preferred orientation parallel to the surface, obtained with the addition of a wide range of oxygen. On neither of the above technologies there is suggestion of a preferred balanced orientation, which allows the presence of both a specific ratio between dense (111) crystal planes and the open structure (200) crystal planes.

### SUMMARY OF THE INVENTION

It is an object of the present invention to provide a piston ring with a coating of a chromium nitride with a crystalline structure by a physical vapor deposition process which has a superior resistance to the initiation of micro-cracks and to the loss of pieces of the coating, related with the propagation of these micro-cracks, in relation to the CrN coating presenting a predominance of (200) crystal planes orientation or a predominance of (111) crystal planes orientation parallel to the coating surface, described in the related art.

The object of the invention is accomplished by a chromium nitride coating with a CrN crystal structure which is characterized by: 1) Columnar crystal morphology having oxygen content in solid solution in the range of 1.2 to 6.8 percent in weight; 2) Morphology having content of dispersed micro-pores in the coating in the range of 1.5 to 4.0% in volume; 3) Crystalline orientation defined by the intensity ratio of dense crystal planes (111) to crystal planes (200) parallel to the coated surface between 0.46 to 0.57 and; 4) Vickers Hardness range from 1650 to 2100 HV, whereby the coating thickness is from 5 to 80 microns.

The (200) crystal plane is more open in nature. This opening is defined by the linear density of a given crystal plane which is low for the planes of the family (200). A coating with such plane, oriented parallel to the surface and perpendicular to the film growth direction, Is able to have higher absorption of internal compressive stresses of the film that develop during the film growth, since it has more space among atoms in this crystal plane. However, due to its more open structure, the (200) crystal plane presents a higher degree of difficulty to move dislocations to relieve shearing external stresses applied to the coated surface. Therefore, a coating having predominant (200) crystal plane orientation parallel to the surface has, as a consequence, lowerfracture tenacity and, consequently, lower surface crack resistance to the external stresses applied. Such compromise of having a relatively higher absorption capacity of internal compressive stress, which is positive to a ceramic coating, with a lower surface crack resistance to external shearing loads, gives an overall balance of the coating out of an optimum performance concerning resistance to generation of micro-cracks on its surface.

On the other hand, a coating having the (111) crystal plane with predominant orientation parallel to the surface develops higher internal stresses. This happens due to the (111) crystal planes' closer atomic nature, I. e., a structure with less space among atoms. This less space among atoms makes the internal stress generated by the coating growth to be higher. On the other hand, there is a higher facility of dislocations through the compact planes, where the (111) plane Is the one that presents the highest facility. This dislocation movement facility gives a higher capacity of relieving shearing external stress applied to the coating. A coating having a predominant orientation of the dense crystal plane (111) parallel to the surface has, as a consequence, higher fracture tenacity, and consequently, a higher resistance to the initiation of cracks originated by external stress applied. Such a compromise is the opposite of the compromise presented when the (200) crystal plane orientation is predominant as described above, i.e., the predominance of crystal planes (111) parallel to the surface has a lower absorption capacity of internal stress and a higher resistance to the initiation of surface cracks due to external shear stress. In a global way, the performance of a crystalline film with a predominance of (111) crystal planes is also far from an optimum performance.

The present invention provides a chromium nitride film of CrN crystal structure able to provide a better compromise between these opposite effects mentioned, I. e., superior balance between internal stress absorption capacity and resistance to the initiation of superficial cracks due to external shearing stress, leading to a superior performance of this coating. Such objective was met by the balance of the relative content of (111) and (200) crystal planes on the coating. The content of each crystal plane in the film is given by the counting intensity of the respective crystal plane by x-ray diffraction and the balance between the content of each crystal plane in the coating is given by the counting intensity ratio of each of the two planes. For coating characterization, the counting intensity ratio between crystal planes (111) and (200) was arbitrarily selected for the indication between the content of both crystal planes. The balance is represented by the ratio of the x-ray diffraction counting intensity of (111) to (200) crystal planes parallel to the substrate.

This proposal of a balance between crystal planes (111) and (200) and its representation through the ratio between its respective counting intensities obtained by x-ray diffraction is a new element, not existing in the prior art, which assures a better balance among properties of each crystal plane and a quantitative definition of the coating crystal structure, which is different from predominance of a specific crystal plane.

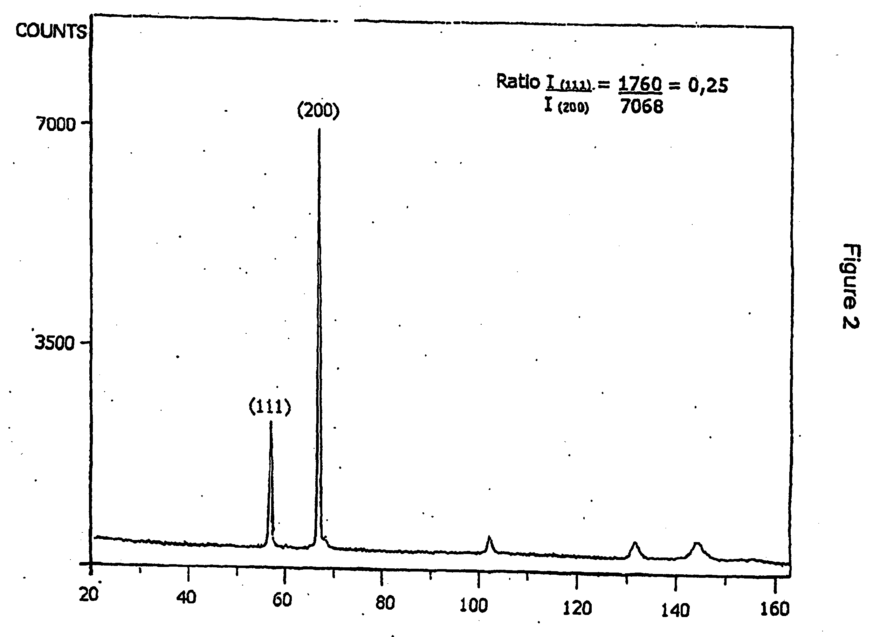

The chromium nitride coating of CrN crystal structure corresponding to the state of the art is obtained from a industrial cathodic arc coating equipment with bias voltage between rings and anode of 0 to - (minus) 100 volts, substrate temperatures of 350 to 500E C, total gas pressures in the range of 5.10⁻⁵ to 1.10⁻² mbar and no intentional addition of oxygen to the nitrogen reacting gas. On these conditions, the chromium nitride film presents a content of residual oxygen up to approximately 0.5 percent in weight. Up to such level of oxygen content, the deposited coating has a predominance of the (200) crystal plane parallel to the substrate. Such predominance is represented by an intensity ratio of (111) crystal plane to the (200) crystal plane of 0.20 to 0.30 as shown by the samples 1 to 3 on table 1 and by the diffraction pattern on figure 2.

The definition of predominance of (200) crystal planes in this coating becomes clear when compared with the reference CrN crystal structure represented by the Information contained on JCPDS card no. 11 - 65, which lists a standardized Intensity of crystal plane (200) of 100 and a standardized intensity of crystal plane (111) of 80. It calculates, thus, an intensity ratio between crystal plane (111) and crystal plane (200) of 0.80. Therefore, a film presenting an intensity ratio inferior to approximately 0.30 is arbitrarily characterized as having predominance of the (200) crystal plane.

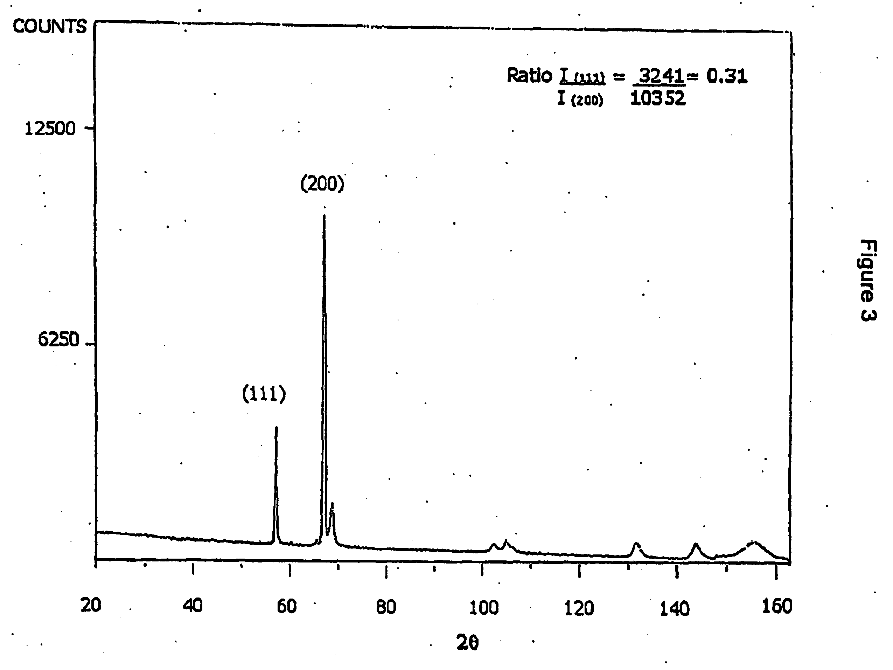

A small addition of oxygen to the reactive gas nitrogen leads to a chromium nitride CrN deposit having an oxygen content approximately from 0.5 to 0.9 percent in weight, but it does not change the intensity ratio between crystal planes (200) and (111) In relation to the coating that does not present intentional addition of oxygen. In both cases, the ratio is around 0.30, as shown by the comparison of coatings of samples 4 and 5 with the coating of samples 1 to 3 on table 1 and also by the comparison of the diffraction pattern on figure 3 with the diffraction pattern on figure 2. The functional evaluation of such a coating, as demonstrated by example 1, showed insufficient resistance to surface crack generation and localized loss of pieces of the coating.
A higher addition of oxygen gas to the nitrogen reacting gas led to the formation of CrN coating having 10.4% in weight of oxygen. This coating presented an intensity ratio between crystal plane (111) and crystal plane (200) of 0.14, as exemplified by the coating of sample 7 on table 1. This coating reflects the state of the technique presented on patent document US 6.149.162, where is preconceived that an addition of 0.5 to 20.0 in weight of oxygen gives origin to a coating with predominant crystal structure (200). The functional evaluation of such coating, as presented on example 3, showed insufficient resistance to surface crack generation and consequent localized loss of pieces of the coating.

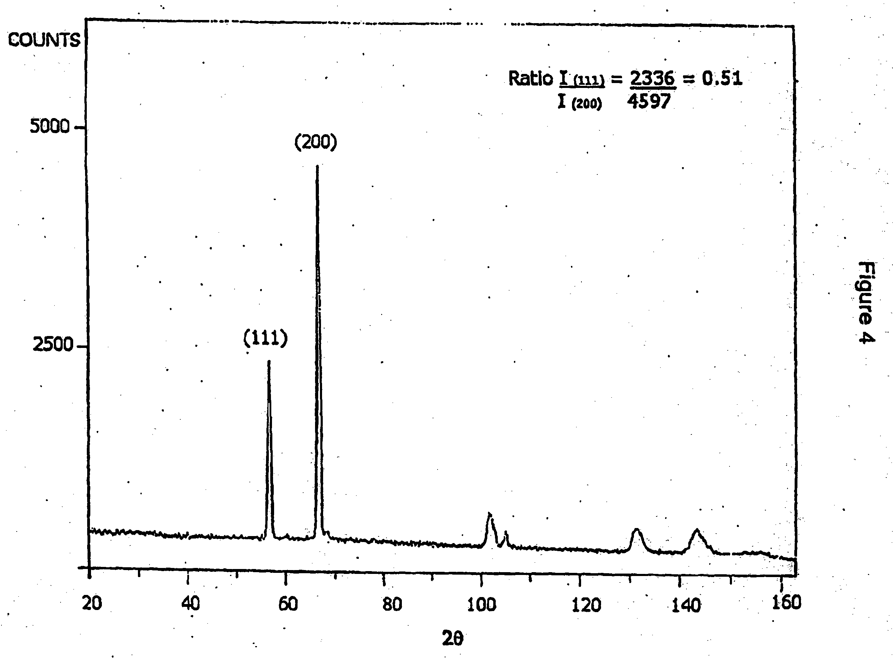

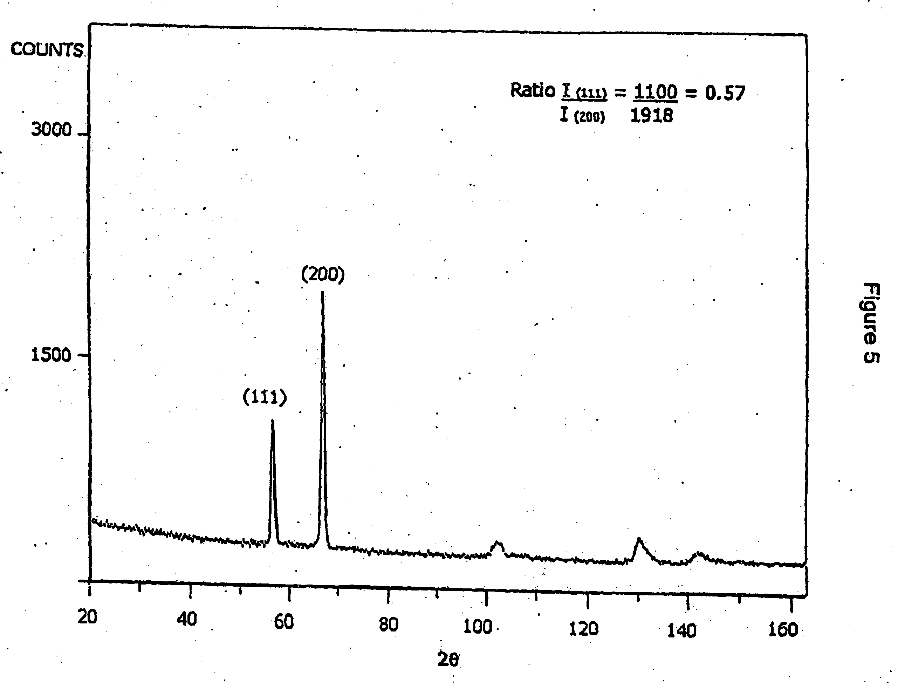

Surprisingly, the coatings with oxygen content in the range of 1.2 to 6.8 percent in weight of oxygen led to an intensity ratio of crystal planes (111) to (200) substantially higher than the described before, showing higher presence of crystal planes (111). As explained before, this higher balance between the presences of crystal planes (111) to (200) is desired. The typical intensity ratio of 0.50 found for these coatings having 1.2 to 6.8% in oxygen weight percent is substantially superior to the values observed of 0.05 to 0.30 obtained with the intentional addition of oxygen, resulting in an oxygen content in the coating superior to approximately 7.0% in weight percent or with intentional addition or without additional oxygen resulting in oxygen contents in the coating inferior to approximately 1.0% in weight percent. The chromium nitride CrN coatings with higher intensity ratios, in the range of 0.46 to 0.57 are exemplified by the coating of the samples 8 to 12 on table 1 and by the diffraction pattern on figures 4 and 5. These samples correspond to the scope of the present invention.

The functional evaluation of the coating samples 8 to 12, presented on examples 2 and 3, respectively, present an absence of micro-cracks on its surface, demonstrating that an Increase In the Incidence of crystal planes (111) parallel to the CrN coating surface and a better balance between these planes and crystal planes (200) produce a superior performance of the chromium nitride coating.

The state of the art described before, represented by a predominance of crystal planes (200) and oxygen content in the coating in the range of 0.5 to 20.0 percent in weight, define a homogeneous behavior set in crystalline function. The present invention demonstrates that a coating having a specific balance between the incidence of crystal plane (111) and crystal plane (200) presents superiorfunctional behavior and that only a narrow range, of approximately 1.2 to 6.8 percent in weight of oxygen, is able to provide a coating with crystal structure objected by the present invention.

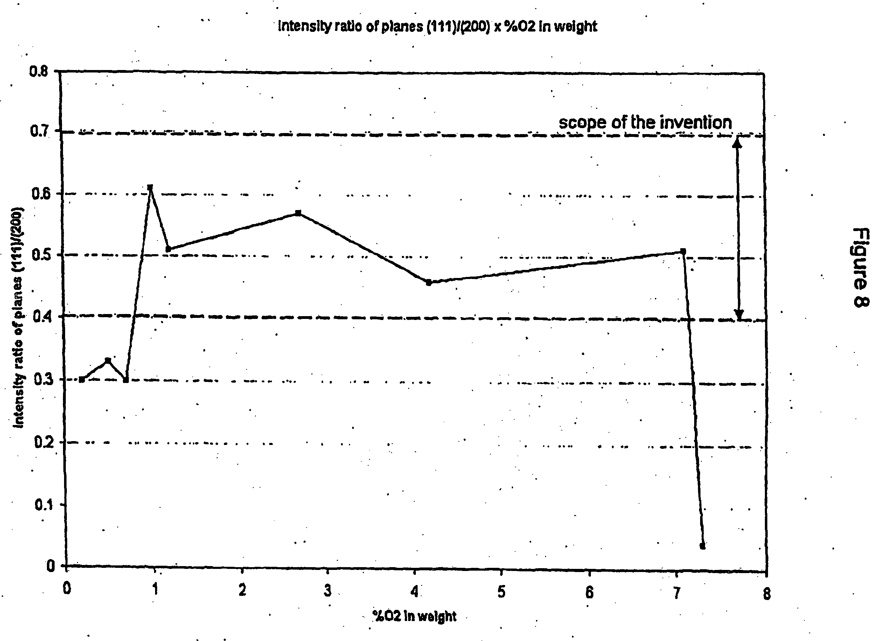

The transition of the crystal structure of a chromium nitride CrN coating with predominance of crystal plane (200) parallel to the surface to a crystal structure with an optimized balance between crystal planes (111) and (200) is not reached with a theoretical and precise oxygen content in the coating. Likewise, experimental techniques have certain dispersion, being necessary to define a functional range of oxygen for the achievement of the product of the present invention as approximately 1.2 percent in weight to approximately 6.8 percent in weight of oxygen in the coating. This necessity is clearly in evidence by the comparison of the coating of samples 6 and 12, respectively representing the state of the art, with 7.3 percent in weight of oxygen In the coating and with intensity ratio between crystal plane (111) and (200) of 0.04, and representing the scope of the present invention with 6.8 percent in weight of oxygen In the coating and with intensity ratio between crystal planes (111) and (200) of 0.51. Likewise, for the inferior level of the functional range of oxygen content, the comparison of coating of samples 5 and 8, respectively representing the state of the art with 0.8 percent in weight of oxygen in the coating and with intensity ratio between crystal plane (111) and (200) of 0.30 and representing the scope of the present invention with 1.2 percent in weight of oxygen in the coating and with intensity ratio of crystal plane (111) and (200) of 0.51. Figure 8 presents a correlation between the oxygen content in the coating and the intensity ratio between crystal plane (111) and (200), illustrating the scope of the present invention.

### BRIEF DESCRIPTION OF THE DRAWINGS

Other objects and features of the present invention will become apparent from the following detailed description considered in connection with the accompanying drawings. It is to be understood, however, that the drawings are designed as an illustration only and not as a definition of the limits of the invention.

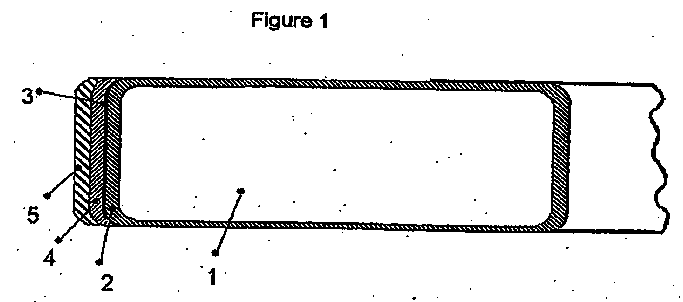

Figure 1 illustrates a cross section of a piston ring showing the base material and the possible layers described in the embodiments of the present invention:
   1. Base material in steel or cast iron
   2. Optional nitrided case
   3. Optional bonding layer
   4. Optional intermediate layer
   5. Chromium nitride layer
Figure 2 shows the X-ray diffraction pattern obtained with Cr tube of the CrN coating with no external addition of oxygen, but having a residual content of 0.3 wt% of oxygen.
Figure 3 shows the X-ray diffraction pattern obtained with a Cr tube of the CrN coating having 0.7 wt% of oxygen obtained by external addition of oxygen.
Figure 4 shows the X-ray diffraction pattern obtained with a Cr tube of the CrN coating having 1.3 wt% of oxygen obtained by external addition of oxygen.
Figure 5 shows the X-ray diffraction pattern obtained with a Cr tube of the CrN coating having 2.7 wt% of oxygen obtained by external addition of oxygen.
Figure 6 shows the X-ray diffraction pattern obtained with a Cr tube of the CrN coating having 4.3 wt% of oxygen obtained by external addition of oxygen.

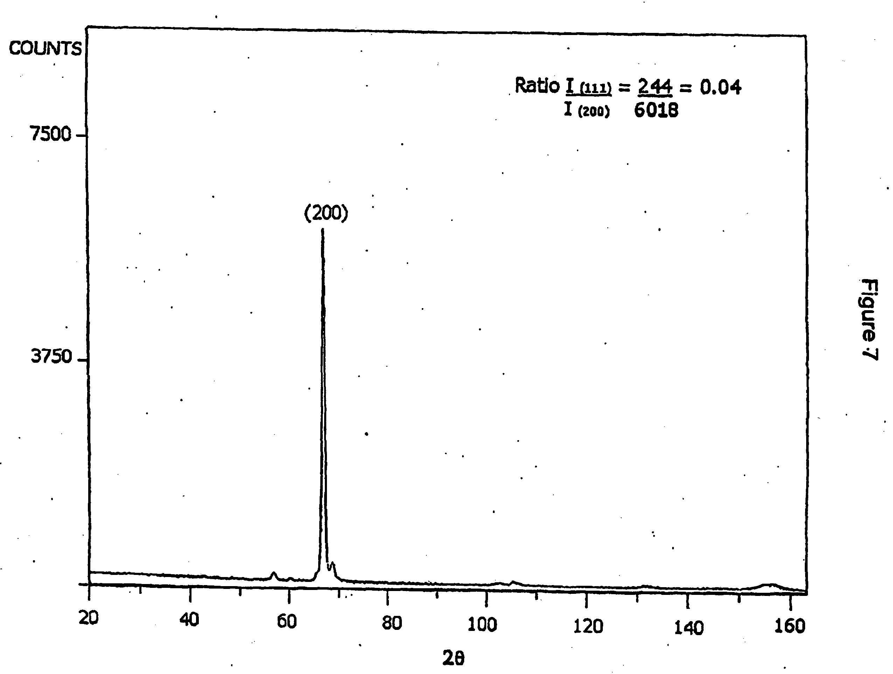

Figure 7 shows the X-ray diffraction pattern obtained with a Cr tube of the CrN coating having 7.3 wt% of oxygen obtained by external addition of oxygen.
Figure 8 shows a graph of the correlation of the X-ray intensity ratio of (111) to (200) planes and the content of oxygen in the coating.

### DESCRIPTION OF THE PREFERRED EMBODIMENTS

Following are described some examples of execution of the scope of the invention described before, as well as the functional evaluation of these examples in comparison with the executions that reproduce the state of the art.

Piston ring prototypes having a diameter of 128mm, a height of 3.0 mm, a radial width of 4.5 mm, for a 450KW heavy duty diesel engine were manufactured onto martensitic stainless steel having 17% Cr, optionally nitrided, ground on its external face, degreased and assembled in appropriate fixtures to receive on its peripheral external face a chromium nitride coating having a CrN crystal structure. This coating was deposited in a vacuum process by physical vapor generated by Industrial cathodic arc equipment - HTC750 Hauzer coater.

After the execution of vacuum in the chamber until a pressure of approximately 5 x 10⁻⁵ mbar, the parts were heated up to 450EC. In the sequence, Argon gas was introduced in a controlled flow, stabilizing the pressure in the vacuum chamber, with the objective of performing an ion etching with Bias voltage between the rings and the anode of - (minus) 900V. After the ion etching, nitrogen gas was Introduced in the chamber with a controlled flow stabilizing the chamber pressure between values of 1x10⁻² to 1x10⁻¹ mbar. For the deposition of the chromium nitride coating having oxygen, a controlled mixture of oxygen and nitrogen gas was made, and this mixture was introduced in the vacuum chamber with a controlled flow stabilizing the chamber pressure between values of 1x10⁻² to 1x10⁻¹ mbar. The deposition took place with a cathodic current of 220 A and voltage between the rings and the cathode of - (minus) 15 V. After deposition, the parts were cooled down to 220≅C, before the vacuum chamber was vented.

The coating samples 4 to 12 on table 1 have intentional addition of oxygen content in the range of 0.7 to 10.4 percent in weight and the total pressure and voltage among rings and anode parameters were kept constant, but it does not mean that they cannot be changed for the obtainment of the crystal structure of the scope of the present invention. The coating samples 1 to 3 represent the chromium nitride execution as the Industrial application with no intentional addition of oxygen. Table 1 presents an evaluation of the counting intensity of crystal planes (111) and (200) obtained by x-ray diffraction, as well as the intensity ratio of crystal planes (111) to (200) of all the samples produced. The following examples will evaluate the functionality in engine test of some of these samples.

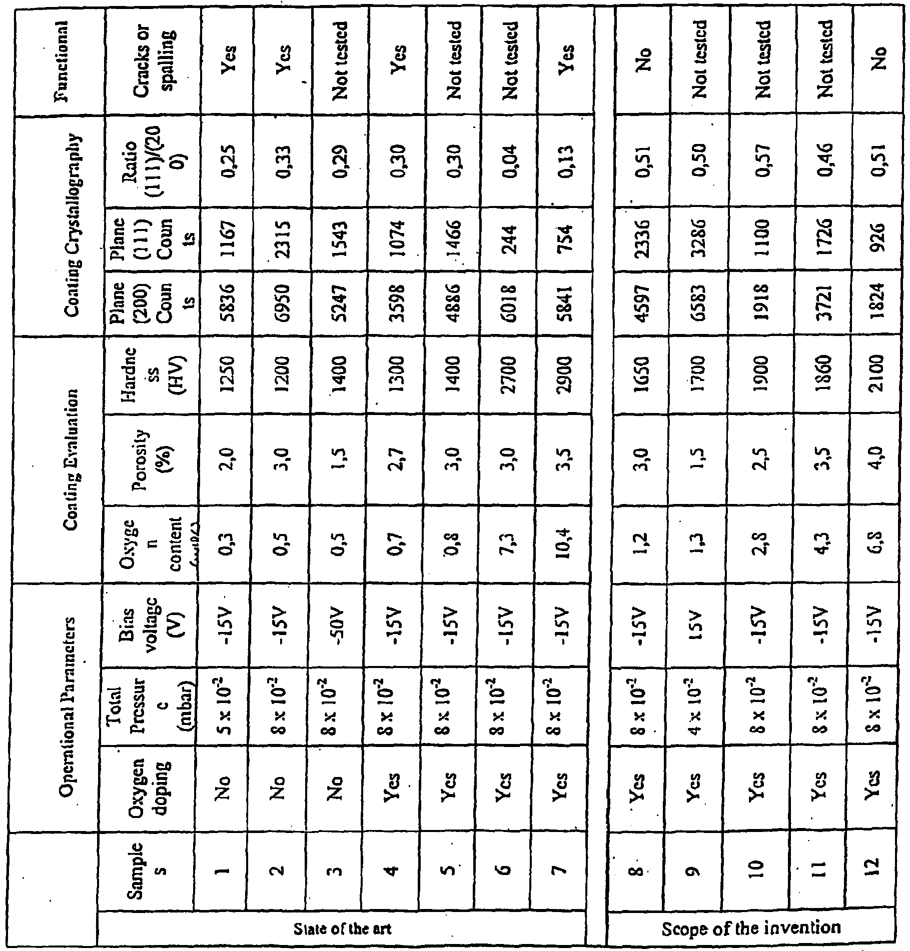

### Example 1

With the above-mentioned method, piston rings were produced represented by sample coatings 1, 2 and 4 on table 1. Two rings of each condition were assembled in a 6 cylinder 450KW heavy duty Diesel engine. The rings were submitted to an accelerated thermal shock test in a dynamometer cell for 500 hours, where the liner and block thermal deformation conditions, besides severe conditions regarding oil film rupture, are particularly keen to the generation of high load on the coated surface of the piston rings. Visual and metallurgical evaluation of the rings after the test was conducted and can be seen on table 2.

The rings of coating samples 1 and 2 on table 1 are representative of the state of the art, and they have residual oxygen content on the coating that was not originated from any intentional addition of oxygen. These coatings present a predominance of (200) crystal plane oriented parallel to the coating surface, and have an intensity ratio between (111) and (200) crystal planes of 0.20 and 0.33, respectively, both rings presented incidence of micro-cracks on the coating and localized loss of pieces of the coating, being a reference for the evaluation of the coatings having oxygen contents not originated by intentional addition.

Two rings of coating sample 4 were produced with the process above-mentioned, wherein it was added a small and controlled flow of oxygen to the nitrogen reacting gas. The coating produced presented the results reported on table 1 and it is representative of the state of the art regarding predominance of crystal planes (200) oriented parallel to the coating surface and presenting intensity ratio between crystal plane (111) and (200) of 0.30. Both rings presented incidence of micro-cracks on the coating and localized loss of pieces of the coating similarto the rings of coating samples 1 and 2, demonstrating a behavior similar and aligned to the level of intensity ratio between crystal planes (111) and (200).

The results lead to the conclusion that a chromium nitride coating with CrN structure and having oxygen content inferior to approximately 1.0 percent in weight, characterized by predominance of crystal plane (200) parallel to the coating surface and having intensity ratio between crystal plane (111) and (200) inferior to approximately 0.30, present incidence of micro-cracks in the engine test described above.

**Table 2: Visual and metallurgical evaluation of rings after engine test.**

| Cylinder # | Sample # | Cracks/Spalling on running face | Oxygen Content (%) | Intensity ratio of planes (111)/ (200) |
|---|---|---|---|---|
| 1 and 3 | 1 | Yes | 0.30 | 0.25 |
| 2 and 5 | 2 | Yes | 0.50 | 0.33 |
| 4 and 6 | 4 | Yes | 0.70 | 0.30 |

### Example 2

With the above-mentioned method, piston rings were produced represented by sample coatings 4, 8 and 12 on table 1. Two rings of each condition were assembled In a 6 cylinder 450KW heavy duty diesel engine. The rings were submitted to an accelerated thermal shock test in a dynamometer cell for 500 hours, in conditions identical to example 1. Visual and metallurgical evaluation of the rings after the test was conducted and can be seen on table 3.

Rings representative of coating sample 4 on table 1 were taken from the same lot of samples used in Example 1 and are representative of the state of the art. Both rings present incidence of micro-cracks on the coating and localized loss of pieces of the coating.

The rings representative of coating samples 8 an 12 on table 1 were produced with the process above-mentioned, wherein it was added a controlled flow of oxygen gasto the nitrogen reacting gas. These coatings were intentionally selected to cover the range of oxygen content in the coating defined on the present invention, of approximately, 1.2 to 6.8 percent in weight of oxygen. With these contents of oxygen, the coatings presented an intensity ratio of crystal planes (111) to (200) of 0.51, and consequently, presenting the balance aimed at the present invention between crystal planes (111) and (200) parallel to the coating surface. All the rings from both samples 8 and 12 presented an absence of micro-cracks after engine test. This result demonstrates the importance of having a specific quantity of crystal planes (111) together with crystal planes (200).

The results lead to the conclusion that a chromium nitride coating of crystal CrN with an intensity ratio between crystal plane (111) and (200) of around 0.51 presents superior resistance to the Initiation of micro-cracks on the coating surface in comparison to the chromium nitride coating with an intensity ratio between crystal planes (111) and (200) of less than approximately 0.30.

**Table 3: Visual and metallurgical evaluation of rings after engine test.**

| Cylinder# | Sample # | Cracks/spalling on running face | Oxygen content (%) | Intensity Ratio between planes (111)/(200) |
|---|---|---|---|---|
| 1 and 3 | 4 | Yes | 0.70 | 0.30 |
| 2 and 5 | 8 | No | 1.20 | 0.50 |
| 4 and 6 | 12 | No | 6.80 | 0.51 |

### Example 3

With the above-mentioned method, piston rings were produced represented by sample coatings 4, 7 and 12 on table 1. Two rings of each condition were assembled in a 6 cylinders 450KW heavy duty Diesel engine. The rings were submitted to an accelerated thermal shock test in a dynamometer cell for 500 hours, in conditions identical to examples 1 and 2. Visual and metallurgical evaluation of the rings after the test was conducted and can be seen on table 4.

Rings representative of coating sample 4 on table 1 were taken from the same lot of samples used in engine tests of Examples 1 and 2 and are representative of the state of the art, as mentioned before. Both rings present incidence of micro-cracks on the coating and localized loss of pieces of the coating.

The rings representative of coating samples 7 and 12 on table 1 were produced with the process above-mentioned, wherein a controlled flow of oxygen gas was added to the nitrogen reacting gas. These coatings were intentionally selected to represent respectively, a chromium nitride coating of the state of the art with a predominance of crystal planes (200) parallel to the coating surface and with intensity ratio between crystal planes (111) and (200) of 0.13 and a chromium nitride coating, of the scope of the present invention, having a mixture of planes (111) and (200), represented by an intensity ratio of crystal planes (111) and (200) of 0.51. Rings representative of coating sample 7 presented an incidence of micro-cracks and localized loss of pieces of the coating after engine test. Rings representative of coating sample 12 presented an absence of micro-cracks, reproducing the result observed on engine test of Example 2. This result emphasizes the importance of having a specific quantity of crystal planes (111) together with crystal planes (200), avoiding a predominance of crystal planes (200) as defined in the state of the art.

The results lead to the conclusion that the most important characteristic influencing the behavior of the chromium nitride coating concerning initiation of micro-cracks is not the oxygen content in the coating, but the crystal structure of it, which must have a minimum content of dense crystal planes (111) parallel to the coating surface. The oxygen content in the coating is important to cause the formation of this crystal structure. The desired crystal structure can only be obtained through a defined range of oxygen content in the coating.

**Table 4: Visual and metallurgical evaluation of rings after engine test.**

| Cylinder# | Sample # | Cracks/spalling on running face | Oxygen content (%) | Intensity Ratio between planes (111)/(200) |
|---|---|---|---|---|
| 1 and 3 | 4 | Yes | 0.70 | 0.30 |
| 2 and 5 | 7 | Yes | 10.4 | 0.13 |
| 4 and 6 | 12 | No | 6.80 | 0.51 |

Accordingly, while only a few embodiments of the present Invention have been shown and described, it is obvious that many changes and modifications may be made thereunto without departing from the scope of the claims.

## Claims

1. A piston ring for internal combustion engines, comprising:
a steel or cast iron base material; and
a coating of chromium nitride deposited by a physical vapour deposition process on a sliding surface of the piston ring,
**characterised in that**
the coating is composed of a columnar crystal structure of CrN with the following features:
[a] an oxygen content in solid solution of from 1.2 to 6.8wt-%;
[b] a content of uniformly dispersed micropores 1.5% to 4.0% in volume of the coating;
[c] an X-ray diffraction intensity ratio of (111) planes to (200) planes parallel to the substrate in the range of 0.46 to 0.57;
[d] a Vickers hardness in the range of 1650 to 2100 HV.

2. A piston ring according to claim 1, wherein the coating has a thickness of about 5 to 80 microns.

3. A piston ring according to claim 1, wherein the base material is made of steel having 10 to 17% chromium.

4. A piston ring according to claim 3, wherein the steel base material is nitrided.

5. A piston ring according the claim 1, wherein the base material is made of nitrided cast iron.

6. A piston ring according the claim 1, further comprising an intermediate bonding layer of chromium, nickel or cobalt deposited between the base material and the coating.

## Patentansprüche

1. Kolbenring für Verbrennungsmotoren, umfassend:
ein Grundmaterial aus Stahl oder Gusseisen; und
eine Beschichtung aus Chromnitrid, die durch einen physikalischen Gasphasenabscheidungsprozess auf einer Gleitfläche des Kolbenrings abgeschieden worden ist,
**dadurch gekennzeichnet, dass**
die Beschichtung aus einer CrN-Stengelkristallstruktur mit den folgenden Merkmalen besteht:
[a] einem Sauerstoffgehalt in fester Lösung von 1,2 bis 6,8 Gew.-%;
[b] einem Gehalt an gleichmäßig verteilten Mikroporen von 1,5 bis 4,0 Vol.-% der Beschichtung;
[c] einem Röntgenbeugungsintensitätsverhältnis von (111)-Ebenen zu (200)-Ebenen parallel zum Substrat im Bereich von 0,46 bis 0,57;
[d] einer Vickers-Härte im Bereich von 1650 bis 2100 HV.

2. Kolbenring nach Anspruch 1, wobei die Beschichtung eine Dicke von etwa 5 bis etwa 8 Mikrometer aufweist.

3. Kolbenring nach Anspruch 1, wobei das Grundmaterial aus Stahl mit 10 bis 17 % Chrom besteht.

4. Kolbenring nach Anspruch 3, wobei das Stahl-Grundmaterial nitriert ist.

5. Kolbenring nach Anspruch 1, wobei das Grundmaterial aus Stahl mit 10 bis 17 % Chrom besteht.

6. Kolbenring nach Anspruch 1, ferner eine Bindungs-Zwischenschicht aus Chrom, Nickel oder Cobalt umfassend, die zwischen dem Grundmaterial und der Beschichtung angeordnet ist.

## Revendications

1. Segment de piston pour moteurs à combustion interne, comprenant
un matériau de base en acier ou en fonte ; et
un revêtement de nitrure de chrome déposé par un processus de dépôt physique en phase vapeur sur une surface de coulissement du segment de piston,
**caractérisé en ce que**
le revêtement est composé d'une structure cristalline en colonnes de CrN avec les caractéristiques suivantes :
[a] une quantité d'oxygène dans la solution solide de 1,2 à 6,8 % en poids ;
[b] une teneur en micropores dispersés de manière uniforme de 1,5 % à 4,0 % en volume du revêtement ;
[c] un rapport d'intensité de la diffraction des rayons X entre les plans (111) et les plans (200), parallèlement au substrat, de l'ordre de 0,46 à 0,57 ;
[d] une dureté Vickers de l'ordre de 1650 à 2100 HV.

2. Segment de piston selon la revendication 1, dans lequel le revêtement a une épaisseur d'environ 5 à 80 microns.

3. Segment de piston selon la revendication 1, dans lequel le matériau de base est fait dans un acier ayant de 10 à 17 % de chrome.

4. Segment de piston selon la revendication 3, dans lequel le matériau de base en acier est nitruré.

5. Segment de piston selon la revendication 1, dans lequel le matériau de base est fabriqué en fonte nitrurée.

6. Procédé selon la revendication 1, comprenant en outre une couche de liaison intermédiaire de chrome, de nickel ou de cobalt déposée entre le matériau de base et le revêtement.
